# EUROPEAN PATENT APPLICATION

(11) **EP 4 443 682 A1**
(43) Date of publication of application: **09.10.2024**
(21) Application number: 24168166.7
(22) Date of filing: 03.04.2024
(51) Int. Cl.: H02G 5/10

(54) **BUSBAR WITH PHASE CHANGE MATERIAL**

(30) Priority: 04.04.2023 DE 102023108560
(71) Applicant: TE Connectivity Solutions GmbH, 8200 Schaffhausen (CH)
(72) Inventor: LUDWIG, Michael, 8200 Schaffhausen (CH); BERGER, Christian, 8200 Schaffhausen (CH); VOITKO, Artem, 8200 Schaffhausen (CH); SANCHEZ, Esteban, 8200 Schaffhausen (CH); BURESCH, Isabell, 8200 Schaffhausen (CH); WAGNER, Astrid, 8200 Schaffhausen (CH); GONZALEZ IZQUIERDO, Santos, 8200 Schaffhausen (CH); BACKE, Sebastian, 8200 Schaffhausen (CH)
(74) Representative: Grünecker Patent- und Rechtsanwälte PartG mbB

(57) **Abstract**

The present invention comprises a busbar (100, 200) enclosing at least one cavity (120, 220), wherein the busbar (100, 200) has at least one web (150, 250) projecting from the wall (110, 210) at least partially into the at least one cavity (120, 220). The at least one cavity (120, 220) is at least partially filled with a phase change material which is in thermally conductive contact with the at least one web (150, 250).

## Description

The present invention comprises a busbar which is at least partially filled with a phase change material.

Short charging times and the associated high currents play an important role in the field of electromobility, particularly in charging and/or drive circuits such as batteries in electrically powered vehicles. In order to shorten the charging time for the batteries contained in these vehicles, the aim is to avoid derating of the charging current output, triggered by current heating, particularly in high-current charging, also known as high-power charging (HPC). This high-power charging requires an ever-increasing current flow from the power source, such as a charging station, to the user, i.e. the vehicle's battery. As a result, the electrical conductive components are subjected to currents of over 500 A, which leads to current heating of the current-carrying components.

In order to reduce possible heating damage to the current conduction path extending from a charging contact element to or into a battery of a motor vehicle and its surroundings, the cross-sectional area of the respective component can be increased so that the current density and the resulting heat development are reduced.

However, increasing the conductor cross-sections is only practicable within certain limits. Larger conductor cross-sections mean increased material consumption and therefore higher costs. In addition, increased conductor cross-sections lead to higher weights. Components with a solid design have the advantage that higher currents can flow through them, but in addition to the extremely high weight, they cause high CO₂ emissions during production.

One known way of counteracting the heating of electrical components is to install active cooling systems. However, active cooling systems require energy themselves and are also technically complex and therefore expensive.

In another known cooling device for cooling battery cells, the cooling device is designed as a busbar arrangement with a cavity containing metal foam. A phase change material is at least partially filled in the spaces between the metal foam. However, the production of this metal foam and its embedding in the busbar arrangement is relatively complex.

In view of increasing climate protection requirements and increased climate awareness, it is therefore advantageous to find more climate-friendly solutions for cooling electrical components that heat up, such as busbars.

The present invention is based on the problem of providing a busbar that allows efficient cooling with a simple and compact design, without reducing the energy to be transmitted with the same geometric cross-section.

This problem is solved by the subject matter of the independent claims. Advantageous embodiments of the present invention are the subject of the dependent claims.

The invention includes the idea that a busbar made of a structured metal profile can be used in such a way that it can be passively cooled by means of a phase change material.

In particular, the present invention comprises the idea of a busbar having a wall which encloses at least one cavity, wherein the busbar has at least one web which projects from the wall at least partially into the at least one cavity. The at least one cavity is at least partially filled with a phase change material which is in thermally conductive contact with the at least one web. In an advantageous embodiment, the web is formed integrally with the wall.

Phase change material is designed to extract heat from the busbar when a certain phase change temperature for the phase transition of the phase change material is exceeded.

When the phase change temperature is reached, further heating of the busbar is delayed as the heat generated is transferred to the phase change material and absorbed by it for the phase transition. This allows the heat to be dissipated from the busbar and stops or delays the temperature increase of the busbar.

Surprisingly, the use of metal profiles, in which the heat is removed by means of volume transport of a suitable material, has shown that such profiles are also suitable as integrated busbars in which no volume transport of a coolant takes place.

The profile of the busbar, which includes at least one web, takes account of the fact that phase change materials usually have the problem of poor heat conduction and only melt on the surface. However, the heat is usually only poorly conducted through the thickness of the phase change material. When using busbars with a profile, the heat can therefore be transferred more effectively to the phase change material and in particular through the thickness of the phase change material.

The metal profiles offer the additional advantage that the phase change material is well connected to the busbar, thus enabling particularly efficient cooling.

The at least one web of the busbar ensures that the heat can be absorbed particularly well by the phase change material and that heat conduction takes place in particular through the thickness of the phase change material.

A busbar is preferably, but not limited to, a rigid component made of an electrically conductive material that acts as part of an electrical circuit and thus enables a connection between a power source and a consumer. Accordingly, a busbar according to the invention can also be designed as a modular connector or be provided with at least one screw connection or connection lug for connection to neighboring parts of the power line path. The busbar according to the invention can be installed in the current conduction path from a charging contact element of the vehicle to the battery or within the battery, for example to electrically connect different cells or modules. Typically, a busbar is an elongated body whose length is usually significantly greater than its diameter or equivalent diameter. Although the busbar usually runs in a straight line, it can also be curved or angled, preferably at an obtuse angle. It is understood that the busbar may also have a more flexible area or element or be formed in such a way, e.g. from a braided band or fabric band, in order to improve the mounting of the busbar in the desired installation space.

The cross-sectional area of the busbar is preferably uniform over the entire length of the busbar and can have any geometry, but the shape of the cross-sectional area of the busbar is preferably rectangular, square, circular or oval.

In an advantageous further development, the busbar has a height a and a width b, whereby the height a is between 1.5 mm and 25 mm and the width b is between 15 mm and 120 mm. Alternatively preferred, the busbar has a circular cross-section with a diameter d of between 5 mm and 25 mm.

The at least one web preferably extends along the height a or along the diameter d of the cross-section of the busbar. Advantageously, the at least one web can also extend over the entire height a.

Phase change materials are generally understood to be materials whose latent heat of fusion is significantly greater than the thermal energy that they can store due to their specific heat capacity. The phase change material therefore provides a latent heat store. With phase change materials, a phase transition takes place when a certain phase change temperature is reached or exceeded. The phase transition does not have to be carried out completely by the phase change material, but can, for example, also occur only partially depending on the variation in the ambient temperature. An example of a phase transition would be the change from a solid to a liquid phase. The phase change material therefore increasingly liquefies when a certain phase change temperature is exceeded and can absorb heat during this process, which is used to carry out this phase transition. If no more heat is then supplied to the phase change material during the phase change or if the phase change material is cooled instead before it is completely liquefied, the phase change does not take place completely and the phase change material becomes increasingly solid again and ultimately changes completely back into the solid phase.

In other words, the phase change material can absorb thermal energy until the phase transition is complete, i.e. the phase change material has completely transitioned from a first phase or aggregate state to a second phase or aggregate state. If the phase change material cools down again in the second phase, it changes back from the second to the first phase or aggregate state, whereby heat is then released again accordingly.

The temperatures at which the phase transitions take place can be defined by selecting the appropriate phase change material.

The phase change material of the invention is preferably designed such that the phase change temperature is between 60 °C and 140 °C, and refers to a solid-liquid transition of said phase change material. Advantageously, a volume of the at least one cavity is 30% - 70% filled with the phase change material. This takes into account any volume changes of the phase change material during or after the phase transition.

Phase change materials can be produced from inorganic or organic compounds, with the latter being further divided into paraffinic and non-paraffinic materials. Furthermore, the use of biodegradable phase change materials and thus the use of a non-paraffinic phase change material based on fatty acids or fatty acid esters or methyl esters is conceivable. For reasons of sustainability, phase change materials based on palmitic acid or on resins such as ben-zoxazines or cardanol + amine are preferred. In special cases, inorganic compounds can also be used.

The phase change material can only contain paraffin and/or sodium, for example. Other materials, or combinations of materials, are also possible.

According to the present invention, a web is understood to be a projecting or protruding element from the wall of the busbar. The web can be formed integrally with the wall or can also be attached to the wall by means of welding, bonding or soldering. The web can preferably protrude from the wall along the entire length of the busbar, but it can also be formed in the longitudinal direction. The web can also have different sizes and shapes, such as pin-shaped, cuboid or rounded. Different thicknesses and depths of the web are possible, depending on the intended use. Furthermore, several webs can be arranged adjacent to each other along the length and/or width of a busbar so that a profile is visible in the cross-section of the busbar.

Such a busbar with a profiled structure advantageously has several webs arranged next to each other along the circumference of the busbar.Advantageously, a cross-sectional area of the at least one web comprises 1% - 60% of the cross-sectional area of the busbar. The geometrically enclosed cross-sectional area of the busbar is preferably between 40 mm² and 350 mm².

According to an advantageous embodiment, the busbar comprises a main section, a first connection section and a second connection section. The at least one cavity is comprised by the main section and enclosed by the wall. Preferably, the at least one cavity extends along the main section of the busbar, not necessarily but preferably over the entire length L of the main section of the busbar. Preferably, the main section has a front end face and/or a rear end face, each of which is arranged perpendicular to the length L of the busbar and closes off the cavity towards the outside. The cavity is usually completely and airtightly enclosed by the wall of the main section. Preferably, the wall of the main section is encased in electrical insulation.

As no coolant flows in the busbar and the busbar or cavity is completely sealed, each busbar is passively cooled independently of other components without the need to maintain special path lengths.

Preferably, the connection sections are arranged on the front and rear end face of the main section and provided with a special surface coating of Sn or a Sn alloy, Ag or an Ag alloy, Ni or a Ni alloy with possible intermediate layers or adhesion promoters or surface structures. The first and second connection sections are preferably attached to the main section by means of welding and/or ultrasonic welding and/or laser welding and/or soldering and/or crimping and/or clamping.

According to a further advantageous embodiment of the present invention, the first connection section and/or the second connection section is designed as a cable lug. Advantageously, the first connection section and/or the second connection section can also be formed integrally with the main section.

The wall can be produced as a unitary component by a manufacturing process such as extrusion, but it is equally possible to join individual sheets or plates, each forming part of the outer circumferential surface, for example by welding or soldering, to form the busbar. The wall can also consist of a braided band or fabric band or the connection of several braided bands or fabric bands. The wall, which can also be made of plastic, for example, can be produced as a shrink tube or by extrusion. In addition, the inner surfaces of the wall that come into contact with the cavity can be provided with a tin coating using conventional tinning processes.

The wall is usually made of an electrically conductive material, in particular metal. Advantageously, the wall can also consist, at least in part, of a conductive metal alloy, e.g. based on copper or aluminum. It is understood that this includes the use of commercially and technically pure aluminum or copper materials. For copper-based materials in particular, it is preferable that the addition of alloying elements is reduced, if not completely avoided. Alloying elements such as oxygen, phosphorus, silicon, lithium, magnesium, boron; tin, chromium, zirconium and/or iron may be present in the selected material, but preferably less than 3% by weight.

The thickness of the wall, which preferably remains constant over the entire busbar, can be customized and can be selected depending on the desired weight, space requirements and/or the necessary current-carrying capacity of the busbar. The wall thickness is preferably at least 0.2 mm.

For a better understanding of the present invention, it is explained in more detail with reference to the embodiments shown in the following figures. The same parts are provided with the same reference signs and the same component designations. Furthermore, some features or combinations of features from the different embodiments shown and described may represent independent inventive solutions or solutions according to the invention. It shows:
- **Fig. 1**: a busbar according to an embodiment of the invention;
- **Fig. 2**: cross-section of a busbar according to a first embodiment of the invention;
- **Fig. 3**: cross-section of a busbar according to a second embodiment of the invention;
- **Fig. 4**: a further cross-section of a busbar according to the first embodiment of the invention;
- **Fig. 5**: a further cross-section of a busbar according to the first embodiment of the invention;
- **Fig. 6**: a further cross-section of a busbar according to the first embodiment of the invention;
- **Fig. 7**: a further cross-section of a busbar according to the first embodiment of the invention;
- **Fig. 8**: a further cross-section of a busbar according to the second embodiment of the invention;
- **Fig. 9**: a further cross-section of a busbar according to the second embodiment of the invention;
- **Fig. 10**: a further cross-section of a busbar according to the second embodiment of the invention;
- **Fig. 11**: a longitudinal section of a busbar according to the first embodiment of the invention.

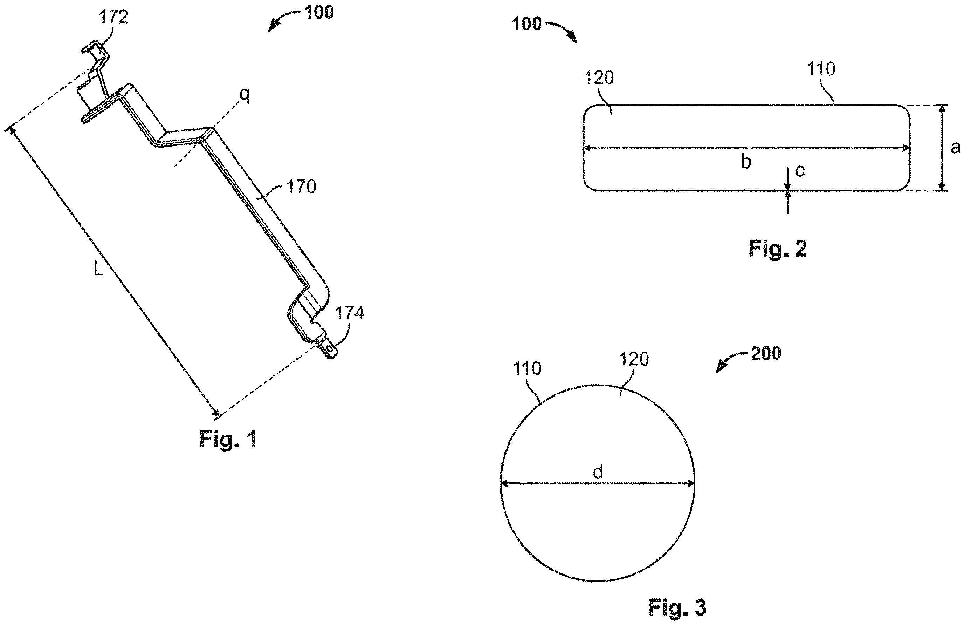

In the following, an advantageous embodiment of a busbar 100 is described with reference to **Figure 1****.** As can be seen from Figure 1, the busbar 100 advantageously has a main section 170, a first connection section 172 and a second connection section 174. The main section 170 extends along a length L and is curved and angled.

Figures 2-10 explained below, and in particular the description of the cavity and the webs, refer to the main section 170 of the busbar.

The busbar 100 is advantageously arranged in a current line path of an electrically powered vehicle between a charging contact element and a battery of the vehicle. The fact that no volume flow of a coolant is provided means that galvanic isolation of different potentials can be achieved easily.

**Figure 2** shows a cross-section of a first embodiment of the busbar 100 along the sectional plane q (Figure 1). The busbar 100 advantageously has an approximately cuboid shape with rounded corners. The busbar 100 has a wall 110, which determines the shape of the busbar 100. The wall 110 encloses at least one cavity 120 of the busbar 100. The cavity 120 can extend continuously along the length L of the main section of the busbar 100 or be limited in the longitudinal direction.

A busbar 100 of this type can have a length L of up to 2 m, for example. Further preferred dimensions of such a busbar 100 are a width b of 15 mm to 120 mm and a height a of 1.5 mm to 25 mm. The thickness c of the wall 110 is, for example, at least 0.2 mm. Such dimensions advantageously offer sufficient stability and are light at the same time.

The wall 110 of the busbar 100 advantageously consists of an electrically conductive material, in particular metal. For example, the wall 110 may comprise aluminum, an aluminum alloy, copper and/or a copper alloy. However, other electrically conductive materials that prove to be suitable for the aforementioned purpose of the busbar are conceivable.

A cross-section of a second embodiment of the busbar 200 according to the invention is shown schematically in **Figure 3****.** Such a busbar is designed with an essentially circular cross-section. The busbar 200 is again bounded by a wall 210, which encloses at least one cavity 220. The cavity 220 can extend continuously along the length L of the main section of the busbar 200 or be limited in the longitudinal direction.

The thickness of the wall 210 is, for example, at least 0.2 mm. The diameter d of the busbar 200 is advantageously in a range between 5 mm and 25 mm. This again achieves sufficient stability with low weight.

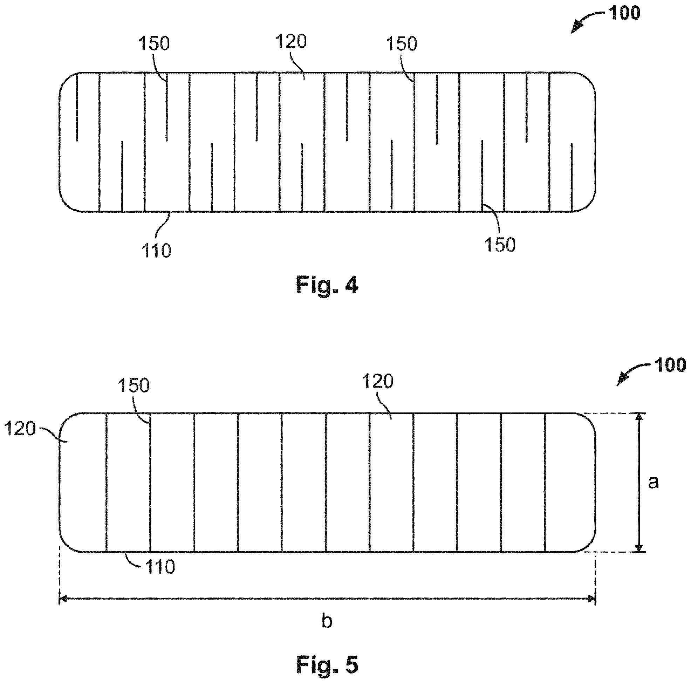

**Figure 4** shows a further cross-section of a first embodiment of a busbar 100 according to the invention. At least one web 150 protrudes at least partially from the wall 110 into the at least one cavity 120. A plurality of webs 150 with different lengths are shown as examples in Figure 4.

In this case, the plurality of webs 150 protrude only partially into the at least one cavity 120 and a further plurality of webs 150 protrude from one side of the wall 120 over the entire height a to the opposite side of the wall 120, so that advantageously a plurality of cavities 120 is formed. By way of example, the webs 150 and thus also the cavities 120 extend along the entire length L of the main section of busbar 100, which results in cavities 120 that are separate from one another and not connected to one another.

However, it is also possible that the webs 150 do not extend continuously along the length L of the busbar 100, but are limited in the longitudinal direction, so that the cavities 120 are connected to each other.

The number and shape of the webs 150 shown in Figure 4 is by no means limited to the illustration shown.

The cavity 120 enclosed by the wall 110 is at least partially filled with a phase change material. In the busbar shown in Figure 4 with several cavities 120, it is advantageous if a plurality or all of the cavities 120 are filled with the phase change material.

As soon as the busbar is heated by the current flow to such an extent that a certain phase change temperature is exceeded, the phase transition of the material takes place. This does not have to occur completely in the entire volume of the phase change material, but can also occur only partially. During the phase transition, the material can absorb heat, which is used to carry out the phase transition. The phase change material can absorb heat until the phase transition is complete.

This has the advantage of delaying the heating of the busbar. Due to the arrangement of the phase change material directly in the cavity 120 of the busbar 100, there is direct contact between the phase change material and the busbar, which additionally increases the cooling effect.

An exemplary representation of the busbar 100 with exclusively continuous webs 150 over the entire height a of the busbar 100 is shown in cross-section in **Figure 5****.** Here, a plurality of webs 150 protrude from the wall 110 such that a plurality of cavities 120 extend continuously or longitudinally along the length L of the main section 170 of the busbar 100. The webs 150 project from one side of the wall 110 over the entire height a of the busbar 100 up to the wall 110 of the opposite side.

Advantageously, the cavities 120 are at least partially filled with the phase change material in order to delay heating of the busbar 100.

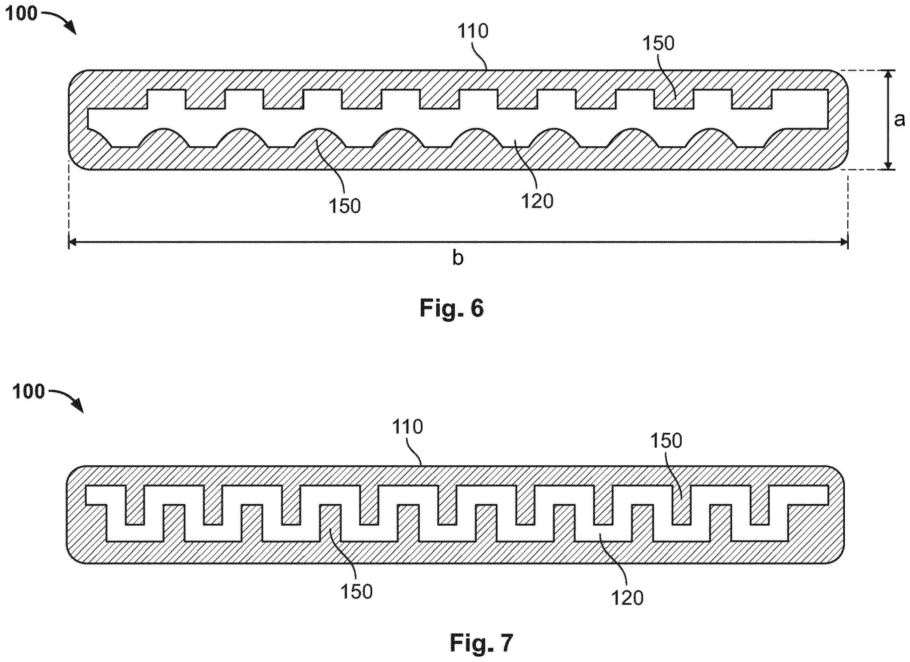

However, the webs shown in Figures 4 and 5 are not limited to the shape shown. With regard to Figures 6 and 7, it is clear that a wide variety of embodiments of the webs are within the scope of the present invention.

The height of the webs protruding into the cavity and the width can be adjusted depending on the area of application and the phase change material used, so that improved heat conduction through the phase change material is ensured.

The cross-sectional area of the webs 150 is advantageously no more than 60% of the cross-sectional area of the busbar 100, so that at least 40% of the cross-sectional area of the busbar can be filled with the phase material.

Further representations of the busbar 100 with different embodiments of the at least one web 150 are shown in Figures 6 and 7.

**Figure 6** shows a further cross-section of the busbar 100 along surface q (see Figure 1). The busbar 100 comprises a plurality of webs 150 along its width b, which are arranged adjacent to one another. Different variants of webs 150 are shown on the two opposite sides of the wall 110. The plurality of webs 150 are advantageously rectangular in shape with or without rounded corners. In the busbar shown in Figure 6, the plurality of webs 150 protrude from the wall 110 in such a way that only a cavity 120 is formed. It is clear that the plurality of webs 150 and the cavity 120 again extend along the entire length L of the main section of the busbar 100, or are limited in the longitudinal direction.

The cross-sectional area of the webs 150 is advantageously no more than 60% of the cross-sectional area of the busbar 100. The special design of the webs 150 as projecting elements can nevertheless ensure improved and uniform heat conduction over the thickness of the entire phase change material.

**Figure 7** again shows a cross-section of a busbar 100 according to the invention. This figure again shows a further embodiment of the webs 150.

As shown, the plurality of webs 150 protrude from the wall 110. The webs 150 are arranged adjacent to one another along the width b of the busbar 100. The plurality of webs 150 is arranged on the two opposite sides of the wall 110.

The webs 150 on the opposite sides of the wall 110 are preferably arranged offset from one another in a comb pattern in such a way that the cross-sectional area of the cavity 120 follows a periodic sequence of elevations and depressions.

This cavity 120 is in turn at least partially filled with the phase change material. In such a configuration of the busbar 100, phase change material with poor thermal conductivity in particular absorbs the heat evenly.

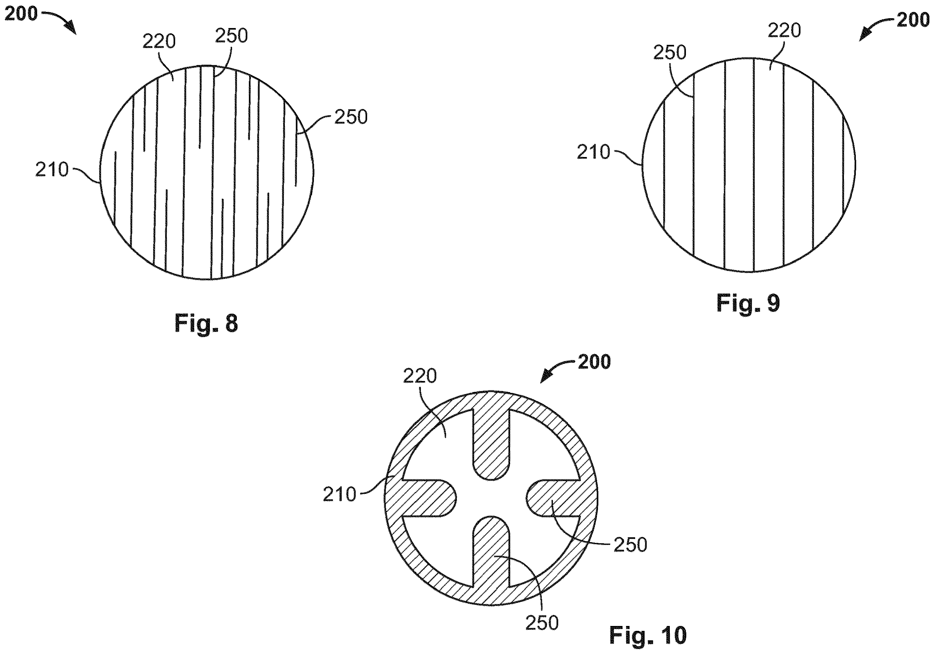

Further representations of a cross-section of the busbar 200 are shown in Figures 8 and 9. It becomes clear that in this embodiment, too, at least one web 250 projects from the wall 210 into the at least one cavity 220.

As an example, the busbar 200 has a plurality of webs 250. The length of the plurality of webs 250, how far they project into the cavity 220 and their shape can vary. The webs 250 in Figures 8 and 9 are exemplary, but the solution according to the invention is not limited to the variants shown and it is clear that embodiments of the webs as explained with reference to the previous figures are also applicable to the busbar 200.

**Figure 8** comprises, by way of example, a plurality of webs 250 which project from the wall 210 partially into the cavity 220 and a plurality of webs 250 which extend continuously along the diameter d of the busbar 200. This advantageously results in a plurality of cavities 220.

**Figure 9** shows, by way of example, only a plurality of webs 250, which extend continuously along the diameter d of the cross-section of the busbar 200 from one side of the wall 210 to the opposite side, resulting in a plurality of cavities 220.

The webs 250 can extend continuously along the length L of the main section of the busbar 200 or be limited in the longitudinal direction.

The cavities 220 are advantageously at least partially filled with a phase change material for passive cooling of the busbar 200.

Figure 10 shows a further cross-section of the busbar 200 in a further embodiment. Here, by way of example, four webs 250, evenly spaced along the circumference of the busbar 200, protrude from the wall 210 into the cavity 220. The busbar 200 thus comprises, by way of example, a cavity 220 which is at least partially filled with the phase change material. This embodiment also enables improved and more uniform heat conduction through the phase change material.

It is clear that advantageous embodiments of the busbar and/or the phase change material are not limited to one or the other embodiment and are applicable regardless of the geometric shape of the busbar and the webs.

Preferably, the cross-sectional area of the webs that project from the wall into the cavity is no more than 60% of the cross-sectional area of the busbar.

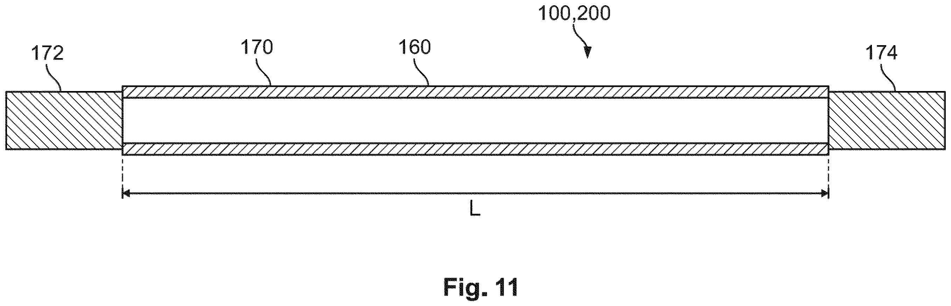

An exemplary busbar 100 in a longitudinal section is shown in **Figure 11**. The wall 110 of the main section 170 has a front end face and/or a rear end face, each of which is arranged perpendicular to the length L of the main section 170 of the busbar 100 and closes off the cavity 120 towards the outside. The cavity 120 is usually completely enclosed by the wall 110.

The first and second connection sections 172, 174 are arranged at the front and rear end faces of the busbar described according to the invention.

The length L along which the cavities 120, 220 and the webs 150, 250 advantageously extend defines the length of the main section 170. Preferably, the wall 110 of the main section 170 may be encased in electrical and thermal insulation 160 to protect surrounding components from the heat generated.

The first connection section 172 and/or the second connection section 174 can be formed integrally with the main section 170 or in multiple pieces. Various attachment methods such as welding, ultrasonic welding, soldering, crimping or clamping are only preferred methods for arranging the first and second connection sections 172, 174 on the main section 170 and do not form an exhaustive catalog.

In order to fasten the busbar 100 when used by means of screws, it is also possible to form the first and second connection sections 172, 174 as cable lugs.

It is clear that the design of the section with connection sections described in Figure 11 is also applicable to the second embodiment of the busbar 200 according to the invention as shown, for example, in Figures 8 to 10.

### List of reference numerals:

| **Reference number** | **Description** |
|---|---|
| 100, 200 | busbar |
| 110, 210 | wall |
| 120, 220 | cavity |
| 150, 250 | web |
| 160 | insulation |
| 170 | main section |
| 172 | first connection section |
| 174 | second connection section |
| a | height of the busbar |
| b | width of the busbar |
| c | wall thickness |
| d | diameter of the busbar |
| L | length of the main area of the busbar |
| q | cross-sectional area |

## Claims

1. Busbar (100, 200) with a wall (110, 210) which encloses at least one cavity (120, 220), wherein
the busbar has at least one web (150, 250) which projects from the wall (110, 210) at least partially into the at least one cavity (120, 220),
wherein the at least one cavity (120, 220) is at least partially filled with a phase change material which is in thermally conductive contact with the at least one web (150, 250).

2. The busbar (100) according to claim 1, wherein
the at least one web (150, 250) is formed integrally with the wall.

3. The busbar (100) according to any one of claims 1 or 2, wherein
the busbar has a height (a) and a width (b) and the at least one web (150) extends along the height (a) and/or wherein the at least one web (150) extends over the entire height (a).

4. The busbar (100, 200) according to one of the preceding claims, wherein
the wall (110, 210) is made of an electrically conductive material, in particular metal and/or wherein the wall (110, 210) of the busbar comprises aluminum and/or an aluminum alloy and/or copper and/or a copper alloy and/or wherein the wall thickness (c) of the wall (110, 210) is at least 0.2 mm.

5. The busbar (200) according to claim 1, wherein
the busbar (200) has a circular cross-section, and the at least one web (250) extends along a diameter (d) of the cross-section.

6. The busbar (200) according to claim 4, wherein
the diameter (d) of the busbar (200) is between 5 mm and 25 mm.

7. The busbar (100, 200) according to any one of claims 1 to 4, wherein
the height (a) of the busbar (100) is between 1.5 mm and 25 mm and the width (b) of the busbar (100) is between 15 mm and 120 mm.

8. The busbar (100, 200) according to one of the preceding claims, wherein
the cross-sectional area of the busbar (100, 200) is between 40 mm² and 350 mm², and wherein
the cross-sectional area of the at least one web (150, 250) is not more than 60% of the cross-sectional area of the busbar (100, 200).

9. The busbar (100, 200) according to one of the preceding claims, wherein
the at least one cavity (120, 220) is sealed airtight.

10. The busbar (100, 200) according to one of the preceding claims, wherein
a volume of the at least one cavity (120, 220) is filled to 30% - 70% with the phase change material.

11. The busbar (100, 200) according to one of the preceding claims, wherein
the phase change material has a phase change temperature between 60 °C and 140 °C and/or wherein the phase change material has a paraffin-based organic material.

12. The busbar (100, 200) according to one of the preceding claims, wherein
the busbar (100, 200) comprises a main section (170), a first connection section (172) and a second connection section (174), and
the main section (170) comprises the at least one cavity (120, 220).

13. The busbar (100, 200) according to one of the preceding claims, wherein
the wall (110, 210) of the main section (170) of the busbar (100, 200) is encased in electrical insulation (160).

14. The busbar (100, 200) according to one of the preceding claims, wherein
the first connection section (172) and/or the second connection section (174) is fixed to the main section (170) by means of a welding process and/or an ultrasonic welding process and/or a soldering process and/or a crimping process and/or a clamping process and/or wherein the first connection section (172) and/or the second connection section (174) are designed as a cable lug.

15. The busbar (100, 200) according to any one of claims 1 to 13, wherein
the first connection section (172) and/or the second connection section (174) are formed integrally with the main section (170).
